Europäisches Patentamt

European Patent Office

Office européen des brevets

(19)

(11) EP 0 744 662 A2

(12) EUROPEAN PATENT APPLICATION

(43) Date of publication:
27.11.1996 Bulletin 1996/48

(51) Int. Cl.$^6$: G03F 7/09

(21) Application number: 96303676.9

(22) Date of filing: 23.05.1996

(84) Designated Contracting States:
DE FR GB IT NL

(30) Priority: 25.05.1995 JP 149689/95

(71) Applicant: JAPAN SYNTHETIC RUBBER CO., LTD.
Tokyo 104 (JP)

(72) Inventors:
• Kusumoto, Shirou
  Yokkaichi-shi (JP)
• Shima, Motoyuki
  Yokkaichi-shi (JP)
• Yumoto, Yoshiji
  Yokkaichi-shi (JP)
• Tsuji, Akira
  Yokkaichi-shi (JP)

(74) Representative: Lamb, Martin John Carstairs et al
MARKS & CLERK,
57-60 Lincoln's Inn Fields
London WC2A 3LS (GB)

(54) Reflection-preventing film-forming composition

(57)    A reflection-preventing film-forming composition comprising non-sublimating fine particles having a radiation-absorbability dispersed in the solvent, which composition is good in storage stability, does not cause the sublimation of the fine particles having a radiation absorbability in a reflection-preventing film, does not cause intermixing and can form a resist pattern excellent in heat resistance, dry-etching property, resolution, precision and the like.

EP 0 744 662 A2

Printed by Rank Xerox (UK) Business Services
2.13.8/3.4

**Description**

BACKGROUND OF THE INVENTION

This invention relates to a reflection-preventing film-forming composition which is useful for fine processing in a lithographic process in which various radiations are used, and is suitable particularly for the production of an integrated circuit device.

In the field of producing an integrated circuit device, the processing size is being made finer in the lithographic process for obtaining a higher level of integration, and in several years, a technique enabling the fine processing in the order of subhalf micron has been developed.

In this lithographic process, in general, a desired resist pattern is obtained by coating a substrate with a resist such as a positive resist consisting of a novolak resin and a quinonediazide type photosensitive agent in a thickness of 0.5 to 10 $\mu$m, transferring the mask pattern to the resulting resist film by means of a stepper and developing the resist film with a suitable developer.

However, there has been such a problem that on the surface of a substrate having a high reflectance such as aluminum, aluminum-silicon alloy, aluminum-silicon-copper alloy, polycrystalline silicon (poly-Si), tungsten silicide or the like used in the above process, or even on the surface of another substrate such as silicon in the case of radiations having some wavelengths (for example, deep ultraviolet ray or the like), the radiation to which the substrate has been exposed is reflected to cause halation, so that the reflected radiation reaches a region which should not be exposed to any radiation and hence a fine resist pattern cannot be reproduced exactly. In order to solve this problem, a method has been tried which comprises adding a radiation absorber such as a dye or the like to the positive resist to lower the radiation permeability of the resist, thereby inhibiting the radiation from being reflected on the substrate surface when the resist film is exposed to the radiation.

However, according to such a method that a radiation absorber is added, the radiation to which the resist film has been exposed cannot reach a sufficiently deep portion of the resist film, and hence, there are such problems that the resist pattern shape obtained is inferior; the sensitivity, resolution, focus depth, developability and the like of the resist film become low; the storage stability of resist is impaired; and the resist performance becomes low.

Therefore, as a substitute for the above-mentioned method, a method has been proposed which comprises forming, on the surface of a substrate having a particularly high reflectance, a reflection-preventing film which absorbs the radiation to which the resist has been exposed, to inhibit the reflection, thereby preventing the halation. As such a reflection-preventing film, there have been known inorganic films such as titanium film, titanium oxide film, titanium nitride film, chromium oxide film, carbon film, $\alpha$-silicon film and the like formed by a method such as vacuum deposition, CVD, sputtering or the like. These inorganic reflection-preventing films are advantageous in that they are excellent in adaptability to steps (excellent step-coverage) on the surface of a substrate, can form a uniform film and are free from such a phenomenon that they are mixed with a resist film (this is called as intermixing) and the resolution, developability and the like of the resist film are not deteriorated. However, they have an electroconductivity and hence are disadvantageous in that they cannot be used in the production of an integrated circuit and require a special apparatus such as vacuum deposition apparatus, CVD apparatus, sputtering apparatus and the like for forming a reflection-preventing film.

On the other hand, there have been proposed organic reflection-preventing films each composed of a (co)polymer of polyamic acid or a sulfone (co)polymer and a dye (see, for example, Japanese Patent Application Kokai (JP-A) No. 59-93,448). This organic reflection-preventing film is not electroconductive and, when dissolved in a suitable solvent, can be coated on a substrate in the same manner as in the case of a resist without using any special apparatus.

However, the above-mentioned organic reflection-preventing films have various problems as mentioned below:

(A) since a part of the dye sublimates from the reflection-preventing film in the course of baking and dry-etching, the reflection-preventing effect is decreased and the contamination of the apparatus due to the sublimation of a film component is caused,

(B) since the reflection-preventing film is intermixed with the resist film, the resolution and developability of the resist film are deteriorated,

(C) when the resist pattern is transferred to the reflection-preventing film by dry-etching after the development, the etching speed of the reflection-preventing film is equal to or lower than the etching speed of the resist film, and hence, the resist pattern is damaged and exact pattern transfer cannot be achieved,

and the like.

SUMMARY OF THE INVENTION

The object of this invention is, therefore, to provide a reflection-preventing film-forming composition which has overcome the above-mentioned problems of the conventional inorganic and organic reflection-preventing films, is good in storage stability, is free from sublimation of any component in the baking and dry-etching steps, does not cause intermixing of a refection-preventing film with a resist film in the course of forming a resist pattern and is capable of producing a resist pattern excellent in heat resistance, dry-etching, resolution, precision and the like.

Other objects and advantages of this invention will become apparent from the following description.

According to this invention, there is provided a reflection-preventing film-forming composition to be used in the production of a semiconductor-producing device which composition comprises (a) non-sublimating fine particles having a radiation absorbability (referred to hereinafter as merely the radiation-absorbable fine particles), (b) a polymeric dispersing agent and (c) an organic solvent, the said radiation-absorbable fine particles (a) being dispersed in the organic solvent (c).

DETAILED DESCRIPTION OF THE INVENTION

The term "radiation-absorbable fine particles" used herein means fine particles which can effectively absorb the radiation to which the resist has been exposed and the radiation reflected on the surface of a substrate in the step of forming a resist pattern, and do not substantially sublimate in the full course of the formation of a resist pattern and do not substantially dissolve in any solvent to be used in the course. However, the tone of the radiation-absorbable fine particles is not critical as far as the radiation-absorbable fine particles have the above-mentioned characteristics.

Such radiation-absorbable fine particles include fine particles of organic pigments such as those of the azo type, the phthalocyanine type, the triphenylmethane type, the quinoline type, quinacridone type, the dioxane type, the perylene type, the isoindolinone type, the anthraquinone type and the like; and fine particles of inorganic pigments such as titanium oxide, lead chromate, lead sulfate, yellow lead, zinc yellow, rouge (red oxide (III)), cadmium red, titanium black, iron black, carbon and the like.

The radiation-absorbable fine particles are particularly preferably fine particles of carbon, and the starting materials therefor include, for example, carbon blacks such as oil furnace black, channel black, thermal black, acetylene black, lamp black, bone black, mineral black, aniline black, graphite and the like; fullerenes such as fullerene $C_{60}$, fullerene $C_{70}$, fullerene nano-tube and the like.

The average particle size of the radiation-absorbable fine particles is not critical as far as a desired reflection-preventing film can be formed on a substrate. However, the average particle size is preferably 2 $\mu$m or less, more preferably 1 nm to 1 $\mu$m and more preferably 1 nm to 0.1 $\mu$m. In this case, when the average particle size exceeds 2 $\mu$m, the smoothness of the reflection-preventing film tends to be lost, the dispersibility of the fine particles in a solvent tends to be reduced and the storage stability of the fine particles tends to become insufficient.

The organic solvent used in this invention includes, for example, 2-methoxyethyl acetate, 2-ethoxyethyl acetate, 3-methoxypropyl acetate, 3-methoxybutyl acetate, ethylene glycol monomethyl ether, ethylene glycol monoethyl ether, ethylene glycol monopropyl ether, ethylene glycol monobutyl ether, ethylene glycol monomethyl ether acetate, ethylene glycol monoethyl ether acetate, propylene glycol monomethyl ether, propylene glycol monoethyl ether, propylene glycol monomethyl ether acetate, propylene glycol monoethyl ether acetate, propylene glycol monopropyl ether acetate, methyl ethyl ketone, 2-heptanone, 3-heptanone, 4-heptanone, cyclohexanone, dioxane, tetrahydrofuran, methyl 2-hydroxypropionate, ethyl 2-hydroxypropionate, methyl 2-hydroxy-2-methylpropionate, ethyl 2-hydroxy-2-methylpropionate, ethyl ethoxyacetate, ethyl hydroxyacetate, methyl 2-hydroxy-3-methylbutyrate, 3-methyl-3-methoxybutyl acetate, 3-methoxybutyl propionate, 3-methyl-3-methoxybutyl propionate, 3-methoxybutyl butyrate, 3-methyl-3-methoxybutyl butyrate, diglyme, ethyl acetate, propyl acetate, butyl acetate, methyl 3-methoxypropionate, methyl 3-methoxybutyrate, methyl pyruvate, ethyl pyruvate, toluene, xylene, cyclohexane and the like. These solvents may be used alone or in admixture of two or more.

The above solvents may, if desired, have added thereto at least one high boiling point solvent such as benzyl ethyl ether, dihexyl ether, diethylene glycol monomethyl ether, diethylene glycol monoethyl ether, diethylene glycol monopropyl ether, diethylene glycol monobutyl ether, acetonylacetone, isophorone, caproic acid, caprylic acid, 1-octanol, 1-nonanol, benzyl alcohol, benzyl acetate, ethyl benzoate, diethyl oxalate, diethyl maleate, $\gamma$-butyrolactone, ethylene carbonate, propylene carbonate, phenyl Cellosolve acetate, N-methylpyrrolidone or the like.

The amount of the solvent contained is preferably 1 to 500 parts by weight, more preferably 10 to 100 parts by weight, per part by weight of the radiation-absorbable fine particles.

The polymeric dispersing agent used in this invention includes, for example, polyoxyethylene alkyl ethers, polyoxyethylene alkylphenyl ethers, polyethylene glycol diesters, ethylene oxide adducts of sorbitol, propylene oxide adducts of sorbitol, ethylene oxide-propylene oxide mixed adducts of sorbitol, ethylene oxide adducts of polyethylenepolyamine, propylene oxide adducts of polyethylenepolyamine, ethylene oxide-propylene oxide mixed adducts of polyethylenepolyamine, ethylene oxide adducts of nonyl phenyl ether-formaldehyde condensate, poly(meth)acrylic acid salts, salts of copolymers of carboxyl group-containing unsaturated monomers and other vinyl compounds, partial alkyl esters of poly(meth)acrylic acid or their salts, polystyrenesulfonic acid salts, formaldehyde condensates of naphthalenesulfonic acid salts, polyalkylenepolyamines, sorbitan-fatty acid esters, fatty acid-modified polyesters, polyamides, tertiary amine-modified polyurethanes, tertiary amine-modified polyesters and the like. These polymeric dispersing agents can be used alone or in admixture of two or more.

Among the above polymeric dispersing agents, preferable are ethylene oxide-propylene oxide mixed adducts of sorbitol, salts of copolymers of carboxyl group-containing unsaturated monomers with other vinyl compounds, tertiary amine-modified polyesters and the like.

The amount of the polymeric dispersing agent contained is preferably 10 to 200 parts by weight, more preferably 50 to 150 parts by weight and most preferably 80 to 120 parts by weight, per 100 parts by weight of the radiation-absorbable fine particles.

When the amount of the polymeric dispersing agent contained is less than 10 parts by weight, no film tends to be obtained when the composition of this invention is spin-coated. On the other hand, when the amount of the polymeric dispersing agent contained exceeds 200 parts by weight, the proportion of the radiation-absorbable fine particles in the film is reduced and hence the reflection-preventing effect of the radiation-absorbable fine particles tends to become insufficient.

The reflection-preventing film-forming composition of this invention may have compounded therewith various additives as far as the desired effect is not impaired.

The above additives include, for example, other radiation-absorbing compounds than the radiation-absorbable fine particles (said compounds are referred to hereinafter as other radiation-absorbers); polymeric binders; reactive diluents; and the like.

The above-mentioned other radiation-absorbers include, for example, dyes such as oil-soluble dyes, disperse dyes, basic dyes, methine dyes, pyrazol dyes, imidazole dyes, hydroxyazo dyes and the like: fluorescent whitening agents such as bixin derivatives, norbixin, stilbene, 4,4-diaminostiblene derivatives, coumarin derivatives, pyrazoline derivatives and the like; ultraviolet absorbers such as hydroxyazo dyes, Tinuvin 234, Tinuvin 1130 (manufactured by Ciba-Geigy) and the like. These other radiation-absorbers can be used alone or in admixture of two or more.

The amount of the other radiation-absorbers contained is preferably 100 parts by weight or less, more preferably 50 parts by weight or less, per 100 parts by weight of the radiation-absorbable fine particles.

The above-mentioned polymeric binder has such an action that the radiation-absorbable fine particles are retained in the reflection-preventing film and the film strength of the reflection-preventing film is improved.

Said polymeric binder includes, for example, epoxy resin, melamine resin, urea resin, aniline resin, phenol resin, unsaturated polyester resin, (meth)acrylic acid ester resin, styrene resin, maleimide resin and the like; copolymer of at least one macromonomer composed of a polymer chain having a polymerizable unsaturation at its one end with at least one other unsaturated monomer (the copolymer being referred to hereinafter as the macromonomer binder); and the like. Particularly preferable is the macromonomer binder.

The macromonomer in the above macromonomer binder includes, for example, compounds each composed of a polymer chain such as polystyrene, polymethyl (meth)acrylate, polyethyl (meth)acrylate, polybutyl (meth)acrylate, polybenzyl (meth)acrylate, polysiloxane or the like and a (meth)acryloyl group bonded at one end of the polymer chain.

The above-mentioned other unsaturated monomers to be copolymerized with the above-mentioned macromonomer include, for example, (meth)acrylic acid esters such as methyl (meth)acrylate, ethyl (meth)acrylate, propyl (meth)acrylate, butyl (meth)acrylate, benzyl (meth)acrylate, 2-hydroxyethyl (meth)acrylate, 2-hydroxypropyl (meth)acrylate, 3-hydroxypropyl (meth)acrylate, dimethylaminoethyl (meth)acrylate, dimethylaminopropyl (meth)acrylate, glycidyl (meth)acrylate and the like; unsaturated carboxylic acids such as acrylic acid, methacrylic acid, crotonic acid, maleic acid, monomethyl maleate, fumaric acid, monomethyl fumarate, itaconic acid, citarconic acid, mesaconic acid, cinnamic acid and the like; aromatic alkenyl compounds such as styrene, $\alpha$-methylstyrene, vinyltoluene, styrenesulfonic acid and the like; alkenyl cyanide compounds such as (meth)acrylonitrile, $\alpha$-chloroacrylonitrile, vinylidene cyanide and the like; and conjugated dienes such as butadiene, isoprene, 2,3-dimethylbutadiene, chloroprene, isoprenesulfonic acid and the like.

The macromonomer binder has a high affinity between the macromonomer unit and the radiation-absorbable fine particles and can form a particularly excellent reflection-preventing film.

Said polymeric binders can be used alone or in admixture of two or more.

The amount of the polymeric binder contained is preferably 100 parts by weight or less, more preferably 1 to 50 parts by weight, per 100 parts by weight of the radiation-absorbable fine particles.

The above-mentioned reactive diluent is a component having a miscibility with the solvent used in the reflection-preventing film-forming composition and being able to polymerize or cross-link by baking or exposure to a radiation after the composition has been coated, and has an action of improving the film strength of the reflection-preventing film similarly to the above-mentioned polymeric binder.

Said reactive diluent includes, for example, unsaturated compounds such as vinyl ester compounds, vinyl cyanide compounds, unsaturated carboxylic acid esters, esters of unsaturated carboxylic acids with unsaturated alcohols, vinyl halide compounds, hydroxyl group-containing vinyl compounds, amino group-containing vinyl compounds, amido group-containing vinyl compounds, carboxyl group-containing vinyl compounds, epoxy group-containing vinyl compounds, aromatic vinyl compounds and the like; polyfunctional epoxy compounds; and the like. In particular, preferable are esters of unsaturated carboxylic acids with polyhydric alcohols, polyfunctional epoxy compounds and the like.

The above esters of unsaturated carboxylic acids with polyhydric alcohols include, for example, poly(meth)acrylates of dihydric or more polyhydric alcohols such as ethylene glycol, propylene glycol, butanediol, hexanediol, polyethylene glycol, polypropylene glycol, glycerin, 1,2,4-butanetriol, trimethylolpropane, pentaerythritol and the like. The polyfunctional epoxy compounds include, for example, polyglycidyl ethers of dihydric or more polyhydric alcohols; polyglycidyl ethers of polyhydric phenol compounds such as resorcinol, bisphenol A, novolak resin and the like; polyglycidyl esters of polycarboxylic acids such as phthalic acid, terephthalic acid and the like; etc. These reactive diluents can be used alone or in admixture of two or more.

The amount of the reactive diluent added is preferably 100 parts by weight or less, more preferable 50 parts by weight or less, per 100 parts by weight of the radiation-absorbable fine particles.

As other additives, there can be compounded a storage stabilizer, an antiseptic agent, a defoaming agent, an adhesive and the like.

The reflection-preventing film-forming composition thus obtained is usually treated so that the solid concentration becomes preferably 3 to 20% by weight, more preferably 3 to 10% by weight, and thereafter, filtered through a filter having a pore diameter larger than the diameters of the radiation-absorbable fine particles, for example, a pore diameter of about 2.5 $\mu$m.

An explanation is made below of a process for forming a resist pattern using the reflection-preventing film-forming composition of this invention.

A process for forming a fine pattern can be applied which comprises:

(1) a step of coating the reflection-preventing film-forming composition of this invention on a substrate,
(2) a step of coating a photoresist solution on the resulting reflection-preventing film, and
(3) a step of irradiating the photoresist film thus formed with a radiation and developing the irradiated photoresist film.

The coating in the above step (1) is carried out by a spin coating method, a flow coating method or the like, preferably by a spin coating method.

After the above step (1) but before the above step (2), a further step of baking is usually provided to volatilize the organic solvent present in the reflection-preventing film-forming composition and simultaneously form a reflection-preventing film on the substrate. In this further step, the baking temperature is, for example, about 90 to 250°C, and the baking time is, for example, 1 to 5 minutes when a hot plate is used or 10 to 60 minutes when an oven is used. According to this, a thickness of the reflection-preventing film is preferably 0.05-1 $\mu$m and more preferably 0.05-0.5 $\mu$m.

In the above step (2), a suitable photoresist film is formed in a desired film thickness, for example, a thickness of 0.5 to 2 $\mu$m, on the reflection-preventing film. In this case, the coating method may be the same as in the step (1).

In the step (2), the necessary components for constituting the photoresist are dissolved in a suitable solvent so that the solids concentration becomes, for example, 5 to 50% by weight, and thereafter, the resulting solution is filtered through a filter having a pore diameter of, for example, about 0.2 $\mu$m to prepare a photoresist solution, after which this solution is applied to the reflection-preventing film by a suitable method such as a spin coating method, a flow coating method or the like. In this case, however, it is needless to say that instead of the preparation of a photoresist, a commercially available resist solution can be used as it is.

After the above step (2), prebaking is usually effected to volatilize the solvent in the photoresist solution, thereby forming a photoresist film. In this case, the prebaking temperature may be varied depending upon the kind of the photoresist used; however, it is preferably about 30 to 200°C, more preferably 50 to 150°C.

As the resist used in the formation of a resist film, there can be used a positive resist composed of an alkali-soluble resin and a quinonediazide photosensitive agent; a negative resist composed of an alkali-soluble resin and a radiation-sensitive cross-linking agent; a positive or negative chemically amplified resist comprising a radiation-sensitive acid generator; and the like.

In the above step (3), the radiation to be used may be a visible light, an ultraviolet ray, a deep ultraviolet ray, an X-ray, an electron beam, a $\gamma$-ray, a molecular beam, an ion beam or the like, and preferable are ultraviolet rays such as an i-line (wavelength: 365 nm), a g-line (wavelength: 436 nm) and the like and deep ultraviolet rays such as a KrF excimer laser light (wavelength: 248 nm), an ArF excimer laser light (wavelength: 193 nm) and the like.

The irradiation with a radiation (referred to hereinafter as the exposure) is usually effected through a desired mask pattern using a stepper. Subsequently, development, washing and drying are conducted to form a desired resist pattern. In this step, after-exposure-baking may be effected for further improving the resolution, the pattern-shape, the developability and the like.

The developer to be used in the formation of a resist pattern includes, for example, alkaline aqueous solutions prepared by dissolving in water sodium hydroxide, potassium hydroxide, sodium carbonate, sodium silicate, sodium metasilicate, ammonia, ethylamine, propylamine, diethylamine, dipropylamine, triethylamine, methyldiethylamine, dimethylethanolamine, triethanolamine, tetramethylammonium hydroxide, tetraethylammonium hydroxide, pyrrole, piperidine, choline, 1,8-diazabicyclo-[5,4,0]-7-undecene, 1,5-diazabicyclo-[4,3,0]-5-nonene or the like.

These developers may have added thereto an aqueous organic solvent, for example, an alcohol such as methanol, ethanol or the like or a surfactant in an appropriate amount.

Incidentally, when the alkaline aqueous solution is used as the developer, water-washing is usually conducted after the development.

Subsequently, using the formed resist pattern as a mask, the dry-etching of the reflection-preventing film is effected by use of a gas plasma such as an oxygen plasma or the like to obtain a resist pattern for processing a substrate.

The reflection-preventing film-forming composition of this invention is excellent in storage stability, and the reflection-preventing film formed using this composition has a high reflection-preventing effect, is free from sublimation of any component during the baking step and the dry-etching step, does not cause intermixing and can give a resist pattern excellent in heat resistance, dry-etching property, resolution, precision and the like.

Accordingly, the reflection-preventing film-forming composition of this invention can greatly contribute particularly to the production of an integrated circuit having a high level of integration.

## DESCRIPTION OF THE PREFERRED EMBODIMENTS

Examples and Comparative Examples are shown below to explain this invention in more detail. However, this invention should not be construed to be limited to the Examples.

The kinds of the resists used in the Examples and Comparative Examples are as follows:

### Kind of resist

Resist A: A positive resist composed of a novolak resin and a naphthoquinonediazide-5-sulfonic acid ester type photosensitive agent (PFR IX120, a trade name of Japan Synthetic Rubber Co., Ltd.)

Resist B: A chemically amplified positive resist composed of a solution obtained by uniformly mixing 100 parts by weight of a polyvinylhydroxystyrene, 50% of the hydroxyl groups of which have been t-butoxycarbonylated (weight average molecular weight = 10,000), 2 parts by weight of triphenylsulfonium hexafluoro-antimonate (radiation-sensitive acid generator) and 306 parts by weight of propylene glycol methylether acetate and then filtering the mixture through a membrane filter membrane filter having a pore diameter of 0.2 $\mu$m.

Resist patterns were formed by the following methods:

### Formation of resist pattern

On a silicon wafer (having a diameter of 4 inches) on which aluminum was applied in a thickness of 0.2 $\mu$m by sputtering, a reflection-preventing film-forming composition was spin coated so that the film thickness became 0.2 $\mu$m to form a reflection-preventing film, and thereafter, the reflection-preventing film was baked on a hot plate at 170°C for 2 minutes. Thereafter, a resist was spin coated on the reflection-preventing film so that the film thickness became 1.5 $\mu$m to form a resist film, and then, the resist film was prebaked on a hot plate at 90°C for 2 minutes. Subsequently, in the case of Resist A, Stepper NSR1505i6A (manufactured by NIXON CORP.) (numerical aperture: 0.45, wavelength: 365 nm) was used and in the case of Resist B, Stepper NSR1505EX (manufactured by NIKON CORP.) (numerical aperture: 0.42, wavelength: 248 nm) was used, as a stepper, to carry out the exposure for only such an exposure time that 0.6 $\mu$m line-and-space pattern could be formed in a 1 : 1 line width (said exposure time being referred to hereinafter as the optimum exposure time). Subsequently, the after-exposure-baking was carried out on a hot plate at 110°C for 1 minute, and thereafter, the exposed resist film was developed with a 2.38% by weight aqueous tetramethylammonium hydroxide solution at 25°C for 1 minute and then washed with water and dried to form a resist pattern.

The evaluation of the performance of reflection-preventing film was conducted by the following methods:

### Evaluation of performance of reflection-preventing film

Reflection-preventing effect

An aluminum substrate having a hole pattern having a depth of 0.6 $\mu$m and a diameter of 2 $\mu$m was spin-coated with a reflection-preventing film-forming composition so that the film thickness became 0.2 $\mu$m to form a reflection-preventing film, which was then prebaked on a hot plate at 170°C for 2 minutes. Thereafter, a resist solution was spin-coated on the reflection-preventing film in the same manner as in the above-mentioned formation of a resist pattern to form a resist pattern. Subsequently, the central portion of the hole pattern was exposed to a radiation for the optimum exposure time to form a line pattern having a width of 1 $\mu$m, and the depth of the notching of pattern formed by the reflection in the optimum exposure time (the depth being referred to hereinafter as the notching depth) was observed.

When the proportion of the notching depth to the 1-$\mu$m wide line pattern was smaller than 10%, the reflection-preventing effect was judged as excellent, when the proportion is 10 to 20%, the effect was judged as good and when the proportion was more than 20%, the effect was judged as bad.

Sublimation resistance

A quartz glass substrate was spin-coated with a reflection-preventing film-forming composition so that the film thickness became 0.2 $\mu$m, to form a reflection-preventing film, which was then prebaked on a hot plate at 150°C for 1 minute. Subsequently, using a self-recording spectrophotometer U-3210 manufactured by Hitachi Ltd., the absorbance (A) at the absorption peak ($\lambda_{max}$) at a wavelength of 300 nm or more was measured, followed by baking on a hot plate at 180°C for 5 minutes and then measuring the absorbance (B) in the same manner as above. (A + B) x 100/A is indicated as the sublimation percentage. When this value was not more than 3%, the sublimation resistance was judged as good and when the value exceeded 3%, the sublimation resistance was judged as bad.

Intermixing (resolution)

In the same manner as in the above evaluation of reflection-preventing effect, the formation of a reflection-preventing film and a resist film, the prebaking, the exposure and the development were conducted, and the dimension of the minimum resist pattern resolved was measured by use of a scanning type electron microscope.

Intermixing (developability)

In the same manner as in the evaluation of the reflection-preventing effect, the formation of a reflection-preventing film and a resist film, the prebaking, the exposure and the development were conducted, and the proportions of scum and undeveloped portions formed owing to the residues of the reflection-preventing film and resist film were examined by use of a scanning type electron microscope.

Heat resistance

A resist pattern was formed, and thereafter, baked on a hot plate at 140°C for 2 minutes, and whether or not the pattern was deformed and the degree of the deformation were examined by use of a scanning type electron microscope.

Dry-etching property

In the same manner as in the above formation of a resist pattern, a reflection-preventing film and a resist film which were separately formed were subjected to dry-etching (pressure: 15 Pa, RF electric power: 300 W, etching gas: oxygen) by use of a dry-etching apparatus DEM-451 (manufactured by Nichiden Anelva K.K.), and the etching speed ratio P between the reflection-preventing film and the resist film was calculated from the equation P = Ra/Rr in which Ra means the etching speed of the reflection-preventing film and Rr means the etching speed of the resist film. When P was more than 1.5, the dry-etching property was judged as excellent and when P was 0.9 to 1.5, the dry-etching property was judged as good, and when P was less than 0.9, the dry-etching property was judged as bad.

Storage stability

The viscosity (C) at 25°C of a reflection-preventing film-forming composition just after its preparation was measured by use of a Model E viscometer (manufactured by Tokyo Keiki), and after this reflection-preventing film-forming composition had been stored at room temperature for 3 months, the viscosity (D) thereof was measured in the same manner as above. (D - C) x 100/C was taken as an index (%) of the storage stability and when the index was less than 2%, the storage stability was judged as excellent, when the index was 2 to 5% the storage stability was judged as good, and when the index was more than 5%, the storage stability was judged as bad.

Examples 1 to 10

Reflection-preventing film-forming compositions to be used in the Examples were prepared according to the following compounding recipes, in which parts are by weight.

Compounding Recipe A

| Carbon black (average particle size: 40 nm, Mitsubishi Carbon Black #20B, a trade name of Mitsubishi Chemical Co., Ltd.) | 40 parts |
|---|---|
| Tertiary amine-modified polyurethane type dispersing agent | 40 parts |
| t-Butyl methacrylate/glycidyl methacrylate/polymethyl methacrylate macromonomer copolymer (monomer composition (parts) = 65/25/15) | 20 parts |
| Methyl 3-methoxypropionate | 900 parts |

Compounding Recipe B

| Carbon black (average particle size: 40 nm, Mitsubishi Carbon Black #20B, a trade name of Mitsubishi Chemical Co., Ltd.) | 40 parts |
|---|---|
| Tertiary amine-modified polyester type dispersing agent | 40 parts |
| t-Butyl methacrylate/2-hydroxyethyl methacrylate/polymethyl methacrylate macromonomer copolymer (monomer composition (parts) = 65/25/15) | 20 parts |
| Trimethylolpropane trimethacrylate | 20 parts |
| Xylene | 40 parts |
| 3-Methoxybutyl acetate | 840 parts |

Compounding Recipe C

| Carbon black (average particle size: 8 nm, Statex, a trade name of Colombian Company) | 40 parts |
|---|---|
| Dispersing agent based on a partial alkyl ester of polyacrylic acid | 40 parts |
| t-Butyl methacrylate/glycidyl methacrylate/polymethyl methacrylate macromonomer copolymer (monomer composition (parts) = 65/25/15) | 20 parts |
| Methyl 3-methoxypropionate | 900 parts |

Compounding Recipe D

| Carbon black (average particle size: 8 nm, Statex, a trade name of Colombian Company) | 40 parts |
|---|---|
| Dispersing agent based on tertiary amine-modified polyester | 40 parts |
| t-Butyl methacrylate/2-hydroxyethyl methacrylate/polymethyl methacrylate macromonomer copolymer (monomer composition (parts) = 65/25/15) | 20 parts |
| Trimethylolpropane triglycidyl ether | 20 parts |
| Xylene | 40 parts |
| 3-Methoxybutyl acetate | 840 parts |

Compounding Recipe E

| Fularen $C_{60}$ (average particle size: 3 nm) | 40 parts |
|---|---|
| Dispersing agent based on tertiary amine-modified polyester | 40 parts |
| t-Butyl methacrylate/glycidyl methacrylate/polymethyl methacrylate macromonomer copolymer (monomer composition (parts): 65/25/15) | 20 parts |
| Xylene | 40 parts |
| 3-Methoxybutyl acetate | 860 parts |

Each of the compositions prepared according to the Compounding Recipes A to E was filtered through a membrane filter having a pore diameter of 2.5 $\mu$m to prepare a reflection-preventing film-forming composition, and the formation of a resist pattern and the evaluation of performance of a reflection-preventing film were conducted in the same manner as above.

The evaluation results obtained are shown in Table 1 and Table 2.

Comparative Examples 1 to 5

In the same manner as in the Examples, except that in Comparative Examples 1 and 4, the reflection-preventing film was not used and in Comparative Examples 2, 3 and 5, the compounding recipes shown in Table 1 were used, the formation of a resist pattern and the evaluation of performance of a reflection-preventing film were conducted.

The evaluation results obtained are shown in Tables 1 and 2.

Table 1

|  | Example | | | | | Comparative Example | | |
|---|---|---|---|---|---|---|---|---|
|  | 1 | 2 | 3 | 4 | 5 | 1 | 2 | 3 |
| Compounding recipe | A | B | C | D | E | None | (*1) | (*2) |
| Kind of resist | A | A | A | A | A | A | A | A |
| Reflection-preventing effect | Good | Good | Excellent | Excellent | Excellent | Bad | Good | Good |
| Sublimation resistance | Good | Good | Good | Good | Good | - | Bad | Bad |
| Intermixing |  |  |  |  |  |  |  |  |
| (Resolution, μm) | 0.38 | 0.39 | 0.38 | 0.39 | 0.38 | - | 0.42 | 0.42 |
| (Developability) | Good | Good | Good | Good | Good |  | Scum existed | Scum existed |
| Heat resistance | Good | Good | Good | Good | Good | Good | Bad | Good |
| Dry-etching property | Excellent | Excellent | Excellent | Excellent | Excellent | - | Excellent | Bad |
| Storage stability | Excellent | Excellent | Excellent | Excellent | Excellent | Excellent | Excellent | Excellent |

Note:
(*1) 8 wt. parts of mixture of poly(butenesulfone) and coumarin 504 (Exciton Company) (weight ratio = 8:1) was dissolved in 92 wt. parts of cyclopentanone.
(*2) 8 wt. parts of a mixture of polyamic acid (hydroxydianiline/pyromellitic dianhydride), curcumic, bicumic, Sudan orange G (10:8:1:1 by weight) was dissolved in 92 wt. parts of mixed solvent of cyclohexanone/N-methyl-2-pyrrolidone (weight ratio = 2:1). Baking conditions of reflection-preventing film in this case was at 200°C for 10 min except for sublimiation test.

Table 2

| | Example | | | | | Comparative Example | |
|---|---|---|---|---|---|---|---|
| | 6 | 7 | 8 | 9 | 10 | 4 | 5 |
| Compounding recipe | A | B | C | D | E | None | (*2) |
| Kind of resist | B | B | B | B | B | B | B |
| Reflection-preventing effect | Good | Good | Excellent | Excellent | Excellent | Bad | - |
| Sublimation resistance | Good | Good | Good | Good | Good | - | Good |
| Intermixing | | | | | | | |
| (Resolution, μm) | 0.32 | 0.33 | 0.32 | 0.32 | 0.32 | - | 0.55 |
| (Developability) | Good | Good | Good | Good | Good | | Scum & undeveloped portion existed. |
| Heat resistance | Good | Good | Good | Good | Good | Good | Good |
| Dry-etching property | Excellent | Excellent | Excellent | Excellent | Excellent | - | - |
| Storage stability | Excellent | Excellent | Excellent | Excellent | Excellent | - | - |

Note: (*2) Same as in Table 1.

## Claims

1. A reflection-preventing film-forming composition to be used in the production of an integrated circuit device, characterized by comprising:

   (1) a non-sublimating fine particles having a radiation absorbability,
   (b) a polymeric dispersing agent,
   (c) an organic solvent,

   said fine particles (a) being dispersed in the organic solvent (c).

2. The composition according to Claim 1, wherein the fine particles (a) are selected from the group consisting of fine particles of organic pigments and inorganic pigments.

3. The composition according to Claim 1, wherein the fine particles (a) are those of carbon.

4. The composition according to Claim 1, wherein the fine particles (a) are selected from the group consisting of carbon blacks and furalens.

5. The composition according to Claim 4, wherein the carbon blacks include oil furnace black, channel black, thermal black, acetylene black, lamp black, bone black, mineral black, aniline black and graphite, and the furalens include furalen $C_{60}$, furalen $C_{70}$ and furalen nanotube.

6. The composition according to Claim 1, wherein the fine particles (a) have an average particle size of 2 μm or less.

7. The composition according to Claim 1, wherein the organic solvent (c) further contains at least one high boiling point solvent selected from the group consisting of benzyl ethyl ether, dihexyl ether, diethylene glycol monomethyl ether, diethylene glycol monoethyl ether, diethylene glycol monopropyl ether, diethylene glycol monobutyl ether, acetonitrile, isophorone, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate, phenyl Cellosolve acetate and N-methylpyrrolidone.

8. The composition according to Claim 1, wherein the polymeric dispersing agent (b) is selected from the group consisting of polyoxyethylene alkyl ethers, polyoxyethylene alkylphenyl ethers, polyethylene glycol diesters, ethylene oxide adducts of sorbitol, propylene oxide adducts of sorbitol, ethylene oxide-propylene oxide mixed adducts of sorbitol, ethylene oxide adducts of polyethylenepolyamine, propylene oxide adducts of polyethylenepolyamine, ethylene oxide-propylene oxide mixed adducts of polyethylenepolyamine, ethylene oxide adducts of nonyl phenyl ether-formaldehyde condensate, poly(meth)acrylic acid salts, salts of copolymers of carboxyl group-containing unsaturated monomers with other vinyl compounds, partial alkyl esters of poly(meth)acrylic acid or their salts, polystyrenesulfonic acid salts, formaldehyde condensates of naphthalenesulfonic acid salts, polyalkylenepolyamines, fatty acid esters of sorbitan, fatty acid-modified polyesters, polyamides, tertiary amine-modified polyurethanes and tertiary amine-modified polyesters.

9. The composition according to Claim 1, wherein the amount of the polymeric dispersing agent (b) contained is 10 to 200 parts by weight per 100 parts by weight of the fine particles (a).

10. The composition according to Claim 1, which further contains a polymeric binder which retains the fine particles in the reflection-preventing film and improves the film strength of the reflection-preventing film.

11. The composition according to Claim 10, wherein the polymeric binder is selected from the group consisting of epoxy resins, melamine resins, urea resins, aniline resins, phenol resins, unsaturated polyester resins, (meth)acrylic acid ester resins, styrene resins, maleimide resins and copolymers of at least one macromonomer composed of a polymer chain having a polymerizable unsaturation at its one end with at least one other unsaturated monomer (the copolymer being referred to hereinafter as the macromonomer binder).

12. The composition according to Claim 10, wherein the amount of the polymeric binder contained is not more than 100 parts by weight per 100 parts by weight of the fine particles.

13. The composition according to Claim 1, wherein the solids concentration in the composition is 3 to 10% by weight.

14. A process for forming a fine pattern comprising:

    (1) a step of coating a reflection-preventing film-forming composition on a substrate,
    (2) a step of coating a photoresist on the resulting reflection-preventing film, and
    (3) a step of irradiating the resulting photoresist film with a radiation and developing the same,
    said reflection-preventing film-forming composition comprising:

    (a) a non-sublimating fine particles having a radiation-absorbability,
    (b) a polymeric dispersing agent, and
    (c) an organic solvent,
    said fine particles (a) being dispersed in the organic solvent (c).